(19) Europäisches Patentamt

European Patent Office

Office européen des brevets

(11) **EP 4 198 804 A1**

(12) **EUROPEAN PATENT APPLICATION**

(43) Date of publication:
**21.06.2023 Bulletin 2023/25**

(21) Application number: **22214488.3**

(22) Date of filing: **19.12.2022**

(51) International Patent Classification (IPC):
**G06F 30/27** (2020.01)    **G06N 3/0442** (2023.01)
**G06N 3/0455** (2023.01)    **G06N 3/092** (2023.01)

(52) Cooperative Patent Classification (CPC):
**G06F 30/27; G06N 3/0442; G06N 3/0455;
G06N 3/092**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **23.12.2021  US 202117645860**

(71) Applicant: **Baidu USA LLC
Sunnyvale, California 94089 (US)**

(72) Inventors:
• **JIANG, Shu**
  **Sunnyvale, 94089 (US)**
• **CAO, Yu**
  **Sunnyvale, 94089 (US)**
• **LIN, Weiman**
  **Sunnyvale, 94089 (US)**
• **LUO, Qi**
  **Sunnyvale, 94089 (US)**
• **XIONG, Zikang**
  **Sunnyvale, 94089 (US)**
• **MIAO, Jinghao**
  **Sunnyvale, 94089 (US)**
• **HU, Jiangtao**
  **Sunnyvale, 94089 (US)**

(74) Representative: **Studio Torta S.p.A.
Via Viotti, 9
10121 Torino (IT)**

(54) **SIMULATION OBSTACLE VEHICLES WITH DRIVING STYLES**

(57)    According to various embodiments, described herein is a method of creating a simulation environment with multiple simulation obstacle vehicles, each with a different human-like driving style. Training datasets with different driving styles can be collected from individual human drivers, and can be combined to generate mixed datasets, each mixed dataset including only data of a particular driving style. Multiple learning-based motion planner critics can be trained using the mixed datasets, and can be used to tune multiple motion planners. Each tuned motion planner can have a different human-like driving style, and can be installed in one of multiple simulation obstacle vehicles. The simulation obstacle vehicles with different human-like driving styles can be deployed to the simulation environment.

Create, by a simulation platform, a virtual driving environment based on one or more of a record file or map information, wherein the virtual driving environment includes a plurality of simulation obstacle vehicles — 1201

Receive, at the simulation platform, a plurality of motion planners, wherein each motion planner is tuned using one of a plurality of learning-based critics, where each of the plurality of learning-based critics is trained using one of a plurality of datasets having different human-like driving styles — 1203

Install, by the simulation platform, each motion planner into one of the simulation obstacle vehicles — 1205

**FIG. 12**

## Description

TECHNICAL FIELD

Embodiments of the present disclosure relate generally to operating autonomous vehicles. More particularly, embodiments of the disclosure relate to creating a simulation environment with obstacle vehicle with different human-like driving styles.

BACKGROUND

An autonomous driving vehicle (ADV), when driving in an automatic mode, can relieve occupants, especially the driver, from some driving-related responsibilities. When operating in an autonomous mode, the vehicle can navigate to various locations using onboard sensors, allowing the vehicle to travel with minimal human interaction or in some cases without any passengers.

The safety and reliability of an ADV are guaranteed by massive functional and performance tests, which are expensive and time consuming if these tests were conducted using physical vehicles on roads. A simulation platform can often be used to perform these tasks less costly and more efficiently.

Typically, a simulation platform for ADV functionality testing can include a simulation environment with obstacles, e.g., vehicles and pedestrians. These obstacles are from prerecorded files, and would behave the same way they did in the physical world. For example, the will not change their behaviors based on the actions of an ADV being tested in the simulation environment, and will not change its direction or stop even if it will bump into the ADV. Thus, existing simulation platforms cannot provide a truly realistic simulation environment.

SUMMARY

In one aspect, a computer-implemented method of creating a simulation environment for simulating autonomous driving vehicles (ADV) is provided, including:

creating, by a simulation platform, a virtual driving environment based on one or more of a record file or map information, wherein the virtual driving environment includes a plurality of simulation obstacle vehicles;

receiving, at the simulation platform, a plurality of motion planners, wherein each motion planner is tuned using one of a plurality of learning-based critics, wherein each of the plurality of learning-based critics is trained using one of a plurality of datasets having different human-like driving styles;

installing, by the simulation platform, each motion planner into one of the simulation obstacle vehicles.

In another aspect, a simulation platform for simulating autonomous driving vehicles (ADVs) is provided, including:

one or more microprocessor with a plurality of applications and services executed thereon, including a simulator, and a record file player;

wherein the simulator is to create a 3D virtual environment based on a record file played by the record file player;

wherein the 3D virtual environment includes a plurality of simulation obstacle vehicles, wherein each of the plurality of simulation obstacle vehicles is a dynamic model with a motion planner tuned using a learning-based critic trained using a dataset with a particular driving style.

With the present disclosure, the simulation environment more resembles a real-world driving environment, which makes a test result more accurate.

BRIEF DESCRIPTION OF THE DRAWINGS

Embodiments of the disclosure are illustrated by way of example and not limitation in the figures of the accompanying drawings in which like references indicate similar elements.

Figure 1 illustrates a motion planner tuning framework 100 according to one embodiment.

Figures 2A, 2B, and 2C illustrate how additional trajectories are generated from demonstration trajectories according to one embodiment.

Figure 3 illustrates input features for the learning-based critic according to one embodiment.

Figures 4A, 4B and 4C illustrate a loss function for training the learning-based critic according to one embodiment.

Figures 5A and 5B illustrate an architectural design of the learning-based critic according to an embodiment.

Figure 6 illustrates an example of an autonomous driving simulation platform for some embodiments of the invention.

Figure 7 is a flow chart illustrating a process of training a learning-based critic for tuning a motion planner of an ADV according to one embodiment.

Figure 8 a flow chart illustrating a process of tuning a motion planner of an ADV according to one embodiment.

Figure 9 illustrates a system for creating simulation obstacle vehicles with human-like driving styles in a simulation platform according to one embodiment.

Figure 10 illustrates a method of creating training data of different driving styles according to one embodiment.

Figure 11 is a block diagram illustrating a process flow of an automatic parameter tuning framework according to one embodiment.

Figure 12 is a flow chart illustrating a process of creating a simulation environment for simulating autonomous driving vehicles (ADV) according to one embodiment.

Figure 13 is a block diagram illustrating an autonomous driving vehicle according to one embodiment.

Figure 14 is a block diagram illustrating a control system of the ADV according to one embodiment.

Figure 15 is a block diagram illustrating an example of the autonomous driving system of the ADV according to one embodiment.

DETAILED DESCRIPTION

Various embodiments and aspects of the disclosures will be described with reference to details discussed below, and the accompanying drawings will illustrate the various embodiments. The following description and drawings are illustrative of the disclosure and are not to be construed as limiting the disclosure. Numerous specific details are described to provide a thorough understanding of various embodiments of the present disclosure. However, in certain instances, well-known or conventional details are not described in order to provide a concise discussion of embodiments of the present disclosures.

Reference in the specification to "one embodiment" or "an embodiment" means that a particular feature, structure, or characteristic described in conjunction with the embodiment can be included in at least one embodiment of the disclosure. The appearances of the phrase "in one embodiment" in various places in the specification do not necessarily all refer to the same embodiment.

According to various embodiments, described herein are methods of creating a simulation environment with multiple simulation obstacle vehicles, and each with a different human-like driving style. Training datasets with different driving styles can be collected from individual human drivers, and can be combined to generate mixed datasets, each mixed dataset including only data of a particular driving style. Multiple learning-based motion planner critics can be trained using the mixed datasets, and can be used to tune multiple motion planners. Each tuned motion planner can have a different human-like driving style, and can be installed in one of multiple simulation obstacle vehicles. The simulation obstacle vehicles with different human-like driving styles can be deployed to the simulation environment to make the simulation environment more resemble a real-world driving environment.

In one embodiment, a method of creating a simulation environment for simulating autonomous driving vehicles (ADV) includes the operations of creating, by a simulation platform, a virtual driving environment based on one or more of a record file or map information, wherein the virtual driving environment includes a plurality of simulation obstacle vehicles; receiving, at the simulation platform, a plurality of motion planners, wherein each motion planner is tuned using one of a plurality of learning-based critics, wherein each of the plurality of learning-based critics is trained using one of a plurality of datasets having different human-like driving styles; and installing, by the simulation platform, each motion planner into one of the simulation obstacle vehicles.

In one embodiment, each of the plurality of training datasets is created from human driving data collected from a plurality of human-driven vehicles, and includes data of a particular driving style from each of the plurality of human-driven vehicles. Each learning-based critic and each motion planner has a same style as the corresponding training dataset.

The disclosure also describes multiple simulation platforms, each with different human-like simulation obstacle vehicles.

In one embodiment, an exemplary simulation platform for simulating autonomous driving vehicles (ADVs) comprise: one or more microprocessor with applications and services executed thereon, including a simulator, and a record file player. The simulator is to create a 3D virtual environment based on a record file played by the record file player, and the 3D virtual environment includes simulation obstacle vehicles, each being a dynamic model with a motion planner tuned using a learning-based critic trained based on a dataset with a particular driving style.

Ruled-based motion planners have many advantages, but requires manual tuning, which typically is inefficient, and highly depends on empirical knowledge. A motion planner in this disclosure can be a speed planner or a planning module of an ADV. In this disclosure, some of the embodiments are illustrated using trajectories, and some of the embodiments are illustrated using speed plans. Embodiments illustrated using trajectories can be similarly illustrated using speed plans, or vice versa.

In an exemplary embodiment, a method of training a learning-based critic includes receiving, at an automatic driving simulation platform, training data that incudes human driving trajectories and random trajectories derived from the human driving trajectories; training by the automatic driving simulation platform a learning-based critic using the training data. The method further includes identifying, by the learning-based critic running at the automatic driving simulation platform, a set of discrepant trajectories by comparing a first set of trajectories, and a second set of trajectories. The first set trajectories are generated by a motion planner with a first set of parameters, and the second set of trajectories are generated by the motion planner with a second of parameters. The method further incudes refining, by the automatic driving simulation platform the learning-based critic based on the set of discrepant trajectories.

In an embodiment, the automatic driving simulation platform include hardware components and services for training neural networks, simulating an ADV, and tuning the parameters of each module of the ADV. The motion planner is one of the module of the ADV, which is represented by a dynamic model in the automatic driving simulation platform. The motion planner can be a planning module, a speed planning module, or a combined module of the planning module and the spend planning module.

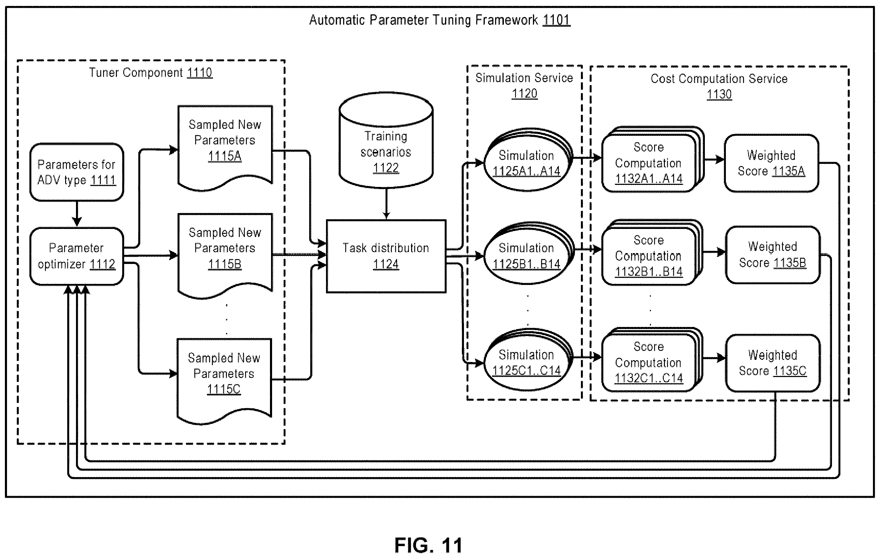

Alternatively, the training phase 105, tuning phase 107, and the evaluation can have their own separate platforms that are communicatively coupled to each other. For example, the training phase can be performed on a training platform for training machine learning models, the tuning phase can be performed on a separate tuning framework (e.g., the automatic parameter tuning framework 1101 described in Figure 11), and the evaluation phase can be performed on a simulation platform.

In one embodiment, the first set of parameters of the motion planner are identified by the learning-based critic for one or more driving environments, and the second set of parameters are a set of existing parameters for the motion planner. Each of the random trajectories is derived from one of the human driving trajectories. The deriving of the random trajectory from the corresponding human driving trajectory comprises determining a starting point and an ending point of corresponding human driving trajectory, varying one of one or more parameters of the corresponding human driving trajectory, and replacing a corresponding parameter of the human driving trajectory with the varied parameter to get the random trajectory. The parameter can be varied by giving the parameter a different value selected from a predetermined range.

In one embodiment, the learning-based critic includes an encoder and a similarity network, and each of the encoder and the similarity network is a neural network model. Each of the encoder and the similarity network is one of a recurrent neural network (RNN) or multi-layer perceptron (MLP) network. In one embodiment, the encoder is a RNN network, with each RNN cell being a gated recurrent unit (GRU).

In one embodiment, features extracted from the training data include speed features, path features, and obstacle features, and each feature is associated with a goal feature, and the goal feature is a map scenario related feature. These extracted features can be used for training the learning-based critic.

In one embodiment, the trained encoder can be trained using the human driving trajectories, encodes speed features, path features, obstacle features, and associated goal features, and generates an embedding with trajectories that are different from the human driving trajectories. The similarity network is trained using the human driving trajectories and the random trajectories, and is to generate a score reflecting a difference between a trajectory generated by the motion planner and a corresponding trajectory from the embedding.

In one embodiment, the loss function used to train the learning-based critic can include an element for measuring similarity between trajectories, which speeds up the training process of the learning-based critic.

In another exemplary embodiment, described herein is a method of tuning a motion planner of an autonomous driving vehicle (ADV). The method includes building an objective function from a learning-based critic; and applying an optimization operation to optimize the objective function to determine a set of optimal parameters for a motion planner of a dynamic model of an autonomous driving vehicle (ADV) for one or more driving environments. The method further includes generating a first set of trajectories using the motion planner with the set of optimal parameters for the one or more driving environments; generating a second set of trajectories using the learning-based critic with a set of existing parameters for the one or more driving environment; and generating a score indicating a difference between the first set of trajectories and the second set of trajectories.

In one embodiment, the method further includes identifying a set of discrepant trajectories by comparing a first set of trajectories and a second set of trajectories; and refining the learning-based critic based on the set of discrepant trajectories.

In one embodiment, the above operations can be repeated in a closed loop until the score reaches a predetermined threshold.

The automatic tuning framework can be deployed to an automatic driving simulation platform, and can include a learning-based critic that serves as a customizable motion planner metric. The learning-base critic can extract a latent space embedding of human driving trajectories based on the driving environment, and can measure the similarity between a motion-planner generated trajectories and a pseudo human driving plan. Thus, using the learning-based critic, the automatic tuning framework can automatically guide a ruled-based motion planner to generate human-like driving trajectories by choosing a set of optimal parameters.

In one embodiment, in the automatic driving simulation platform, the motion planner can be a planning module or a speed module of a dynamic model of an ADV. The motion planner is parameterized and thus highly configurable. The automatic tuning framework can use the Bayesian parameter searching method or a sequential model-based algorithm configuration to speed up the parameter tuning process.

In one embodiment, the learning-based critic acts as the objective function that describes the costs of various parameters of a motion planner. Thus, by optimizing the learning-based critic, the automatic tuning framework can identify a set of optimal parameters to optimize the parameters of the motion planner.

In one embodiment, the learning-based critic is trained using an inverse reinforcement learning (IRL) method, and can quantitatively measure trajectories based on human driving data. With this learning-based critic, the automatic tuning framework, which also includes simulation-based evaluation, can enable a ruled-based motion planner to achieve human-like motion planning.

Compared to existing tuning frameworks, the automatic tuning framework can remove human efforts in tedious parameter tuning, reduce tuning time, and make the deployment of the motion planner more scalable. Further, the physical and safety constraints in the rule-based motion planner are retained, which maintains reliability. In addition, when trained with different human driving datasets, the learning-based critic can extract different driving styles, which can be further reflected in motion planners tuned by the automatic tuning framework to create different personalized motion planners.

The embodiments described above are not exhaustive of all aspects of the present invention. It is contemplated that the invention includes all embodiments that can be practiced from all suitable combinations of the various embodiments summarized above, and also those disclosed below.

Motion Planner Tuning Framework

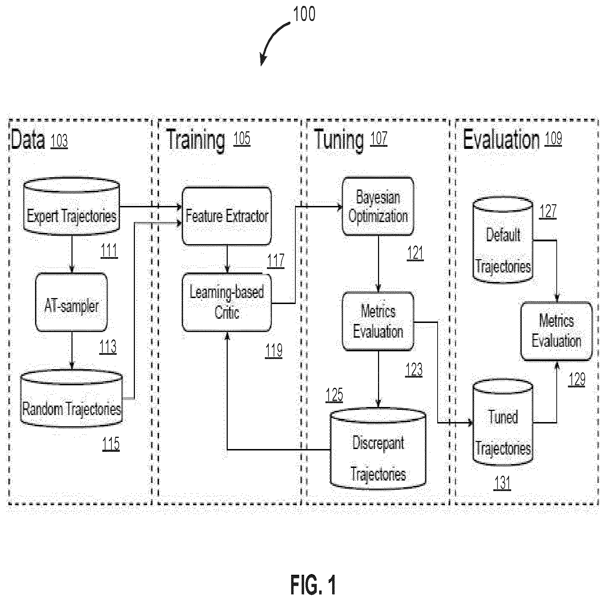

Figure 1 illustrates a motion planner tuning framework 100 according to one embodiment. The motion planner framework includes a data phase 103, a training phase 105, a tuning phase 107, and an evaluation phase 109, each phase including a number of software and/or hardware components that complete a set of operations for performing a number of functions.

In the data phase 103, expert trajectories 111 are collected, from which random trajectories 115 are generated using an acceleration-time sampler (AT-sampler) 113. The expert trajectories 111 are human driving trajectories generated by one or more ADVs that are manually driven by human beings, e.g., hired professional drivers.

The expert trajectories 111, also referred to as demonstration trajectories, can be contained in a record file recorded by the ADV while it is being manually driven. Each expert trajectory can include points that the ADV is expected to pass, and several driving parameters of the ADV, such as heading, speed, jerks, and acceleration of the ADV at each point.

In one embody, the AT-sampler 113 can be a software component used to generate additional trajectories to increase the size of the training dataset. Since the expert trajectories 111 are collected by vehicles that are manually driven by human beings, they are limited by available resources, e.g., the number of professional drivers that can be hired. The AT-sampler 113 can generate additional trajectories from the expert trajectories 111.

The random trajectories 115 are the additional trajectories generated by the AT-sampler 113. From each expert trajectory, i.e., human driving trajectory, the AT-sampler 113 can generate many other trajectories (e.g., 1000 trajectories), each generated trajectory having the same starting point and destination point as the original expert trajectory, but having one or more different points in the middle, and/or having variations in one or more of the driving parameters of the ADV on each point on the expert/demonstration trajectory.

As an illustrative example, an expert trajectory starts with point A, ends with Z, and passes points B, C, E, F, and G, with accelerations of $0.1 m/s^2$, $0.5 m/s^2$, $0.9 m/s^2$, $0.2 m/s^2$, and $0.7 m/s^2$ at each point respectively. From this expert trajectory, the AT-sampler 113 can use different accelerations at one or more of the points B, C, E, E, F, and G to generate different trajectories. The different accelerations can be selected from the range between $0.1 m/s^2$ and $0.9 m/s^2$. The AT-sampler 113 can sample different accelerations from the range and use them to generate different trajectories.

In one embodiment, to avoid generating unrealistic samples and to reduce the sample space, the AT-sampler 113 can infer speed and jerk parameters from the acceleration parameters.

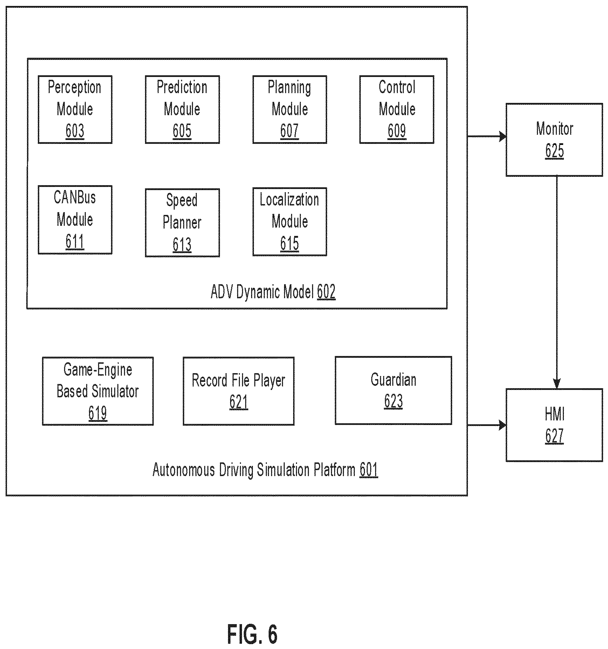

In the training phase 105, a feature extractor 117 can extract features from the demonstration trajectories 111 and the generated trajectories 115. The feature extractor 117 can be part of an automatic driving simulation platform that will be described in details in Figure 6. The extracted features can be used to train a learning-based critic 119. Examples of the extracted features can include speed, acceleration, jerk, and heading of an ADV each point on a trajectory. The operations of the training phase 105 can be performed on a separate training platform.

In one embodiment, the demonstration trajectories 111 and the generated trajectories 115 are associated, and this corresponding relationship can be considered during the training of the learning-based critic 119. For example, only when a generated trajectory has a single association with one demonstration trajectory can the loss of that generated trajectory be computed. In one embodiment, the inverse reinforcement learning (IRL) is used to train the learning-based critic. The IRL is a training algorithm for learning the objectives, values, or rewards of an agent (i.e. the learning-based critic 119) by observing its behavior.

In the tuning phase 107, a Bayesian optimization operation 121 is performed by the automatic driving simulation platform to tune a motion planner of an ADV by optimizing an objective function built from the learning-based critic 119.

For example, if θ denotes a parameterized deterministic policy, which is a mapping from a set of environment configurations sequence C to an ego vehicle's configuration sequence C. Thus, θ can denote a motion planner or a speed planner. The mapping is fixed when parameters of the motion planner or the speed planner are fixed. Further, let's assume that $f_{critic}$ denotes a cost that a learning-based critic generates to measure the quality of speed plans or trajectories generated by a speed planner or the motion planner with respect to the configurations C. Then, an objective function can be built from the learning-based critic:

$$\Phi^* = \underset{\Phi}{\arg\min}\, F_{\text{critic}}(\theta_{\Phi}^{sp}, \mathcal{C})$$

In the above objective function, $\theta_{\Phi}^{sp}$ denotes a speed planner, C is a set of predicted environment configurations generated in various scenarios, and $F_{critic}$ is a composition of costs, each being a $f_{critic}$ for a different speed plan of a range of speed plans generated by a speed planner. Multiple speed plans are used in order to accurately reflect the performance of the speed planner, because a single speed plan may fail to reflect the motion planner's performance in different scenarios. The automatic driving simulation platform can use the Bayesian optimization operation 121 to identify a set of parameters for the speed planner that would minimize the total cost $F_{critic}$. That set of parameters would be the optimal parameters for the speed planner. Thus, the automatic driving simulation platform tunes the speed planner by identifying a set of parameters that would minimize the total cost of a range of speed plans generated by the speed planner.

In one embodiment, the tuning process of the speed planner can start by generating a first set of speed plans using the speed planner with a first set of parameters. Each generated speed plans can be provided as input to the learning-based critic, which can generate a score indicating how close the generated speed plan is to a human driving speed plan. The closer, the lower the score. A total score for the first set of speed plans can be calculated to get a first total score.

Then, a second set of parameters is selected for the speed planner, which generates a second set of speed plans. For the second set of speed plans, the learning-based critic can be generated a second total score. The process can continue until a total score that meets a predetermined threshold is find or a predetermined number of iterations is reached.

The above description uses the tuning of the speed planner as an example to illustrate how the parameters of the speed planner is tuned. The motion planner can be similarly tuned as described above.

In the tuning phase 107, some discrepant trajectories 125 can be identified. The discrepant trajectories 125 are corner cases in which the motion planner performs as expected but the learning-based critic 119 reports high costs, or vice versa. These corner cases exist because it is difficult to collect data for some rare scenarios. Thus, the learning-based critic 119 may have been trained without using data for the rare scenario. When such a rare scenario is encountered during the tuning phase, the learning-based critic 119 is unlikely to report an accurate cost. These corner cases can be high-cost good behavior cases or low-cost bad behavior cases. The automatic driving simulation platform, while tuning the parameters of the motion planner, can collect the corner cases, and add them to the training data set for refining the learning-based critic 119.

In the evaluation phase 109, the tuned motion planner can be deployed to an autonomous driving simulation platform. Default trajectories 127 and tuned trajectories 131 can be compared in terms of the evaluation metrics 129, which can be the same set of evaluation metrics as the evaluation metrics 123. The default trajectories 127 are generated by the motion planner before it is tuned. The autonomous driving simulation platform can use the same record file to recreate virtual environments for generating both the default trajectories 127 and the tuned trajectories 131. Results of the comparison between the default trajectories 127 and the tuned trajectories 131 can be used to refine the learning-based critic 119 and the evaluation metrics 123 and 129.

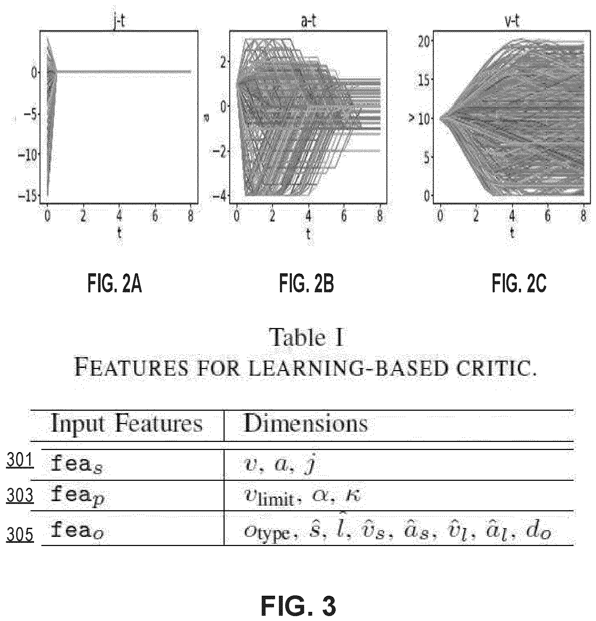

Figures 2A, 2B, and 2C illustrate how additional trajectories are generated from demonstration trajectories according to one embodiment. Figure 2B shows an example acceleration-time space, which includes a range of accelerations against time. An AT-sampler such as the one 113 described in Figure 1 can sample the acceleration-time space and use the sampled accelerations to generate jerk features as shown in Figure 2A, and speed features as shown in Figure 2C. Various combinations of accelerations, jerks and speeds can be used to generate additional trajectories corresponding to each demonstration trajectory.

Figure 3 illustrates input features for the learning-based critic according to one embodiment.

As shown in Figure 3, the input features for the learning-based critic include speed-related features 301, path-related features 303, and obstacle-related features 305. The speed features 301 can include speed, acceleration, and jerk. The path-related features 303 can include speed limit, heading angle, and curvature. The obstacle-related features can include features in six relative directions to the ego car; the fix directions are left-front, front, right-front, left-rear, rear, and right-rear. Examples of the obstacle-related features can include obstacle type, relative position, speed, acceleration in Frenet Frames and Euclidean distance to the ego vehicle. Each of the above features can be associated with one of a map scenario related metrics for a trajectory.

In one embodiment, all the above features can be extracted from record files recorded by various ADVs manually driven by human drivers, e.g., hired professional drivers.

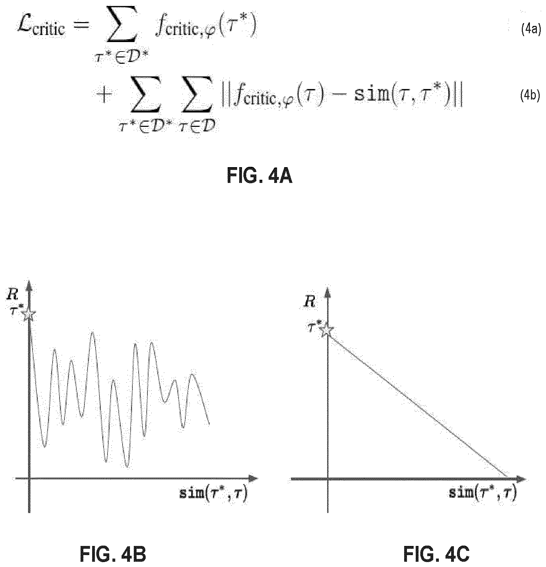

Figures 4A, 4B and 4C illustrate a loss function for training the learning-based critic according to one embodiment.

In one embodiment, the learning-based critic can be trained using the inverse reinforcement learning (IRL) with human driving data and tweaked human driving data. An AT-sampler can tweak the human driving data to derive additional data to increase the size of the training dataset.

The purpose of the IRL is to minimize or maximize a parameterized objective function. When the objective function is to be minimized, it can be parameterized as a cost function, loss function, or error function. When the objective function is to be maximized, it can be parameterized as a reward function.

Figure 4A illustrates a loss function for training the parameterized learning-based critic according to one embodiment.

As shown in Figure 4A, the loss function $\mathcal{L}_{critic}$ is to be minimized such that the parameterized critic $f_{critic, \varphi}$ can be optimized and thus considered as being trained. A parameterized critic is a critic that is represented in terms of parameters.

In the loss function $\mathcal{L}_{critic}$, $\tau$ is a trajectory in the training dataset D, and $\tau^*$ is a trajectory in the demonstration trajectories D*.

As shown, the loss function $\mathcal{L}_{critic}$ includes two parts 4a and 4b. Part 4a represents the cost of human driving trajectories, and thus minimizing part 4a would decrease the cost of the human driving trajectories. To avoid $f_{critic, \varphi} (\tau^*)$ decreasing too much, $f_{critic, \varphi} (\tau^*)$ is limited to values that are greater than 0. Minimizing part 4b means regression $f_{critic, \varphi} (\tau)$ with $sim(\tau, \tau^*)$. The term $sim(\tau, \tau^*)$ signifies similarity of a trajectory to a human driving trajectory. Thus, the loss function $\mathcal{L}_{critic}$ both minimizes the cost of the human driving trajectories and regresses on the similarity of a trajectory to a corresponding human driving trajectory.

The benefits of using the above loss function to train the learning-based critic are shown by Figures 4B and 4C, where the y-axis represents reward, and the x-axis $sim(\tau, \tau^*)$ signifies the similarity of a trajectory to one optimal trajectory $\tau^*$.

Figure 4B shows the training using the traditional max-entropy IRL that does not consider the trajectory similarity, and Figure 4C shows the training using regression on the trajectory similarity property.

In one embodiment, the similarity between two trajectories can be defined with $L_1$ distance between the normalized speed features of the two trajectories. The $L_1$ distance is also called Manhattan distance, and is a sum of absolute distances between measures in all dimensions (e.g., speed, acceleration, jerk).

As shown in Figure 4B and 4C, when $sim(\tau, \tau^*)$ is 0, meaning when there are no difference between a trajectory and a human driving trajectory, the reward R is maximized in both Figure 4B and 4C.

However, in Figure 4B, the entropy of all the possible trajectories is to be maximized without considering similarity between any trajectories. Thus, the reward function in Figure 4B has many local optimals, which make optimization more difficult, compared to Figure 4C, where the reward function does not have any local optimal.

When a trajectory is more similar to the human driving trajectory, a higher reward can be expected. In Figure 4C, a quantitative measure is given for the similarity of a trajectory to a human driving trajectory, which further benefits the optimization.

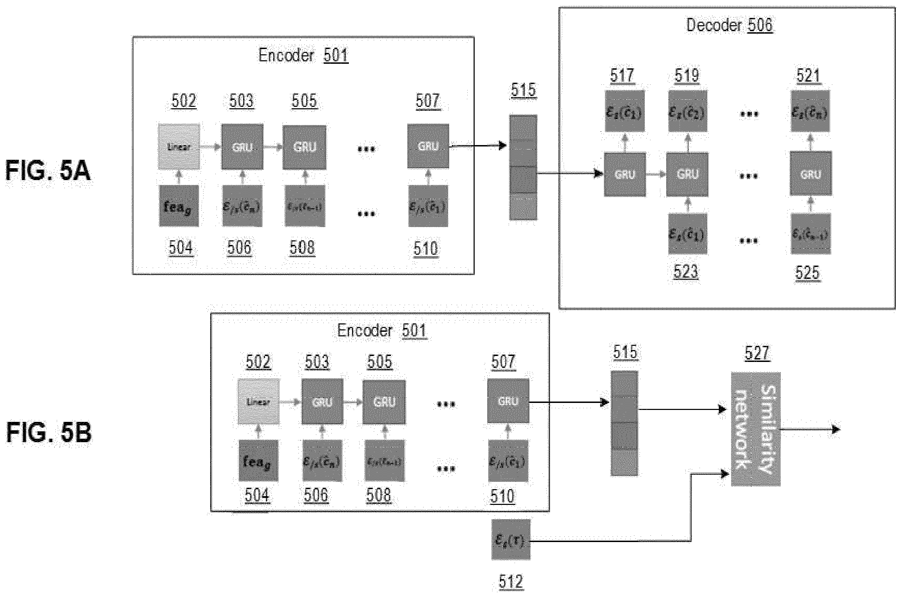

Figures 5A and 5B illustrate an architectural design of the learning-based critic according to an embodiment. Figure 5A shows a training process of an encoder 501. The encoder 501 and a decoder 506 are trained together using human driving trajectories.

During the training process of the encoder 501, the encoder 501 encodes the environment features $\mathcal{f}_s(\hat{c})$ and goal feature $fea_g$ into an embedding 515. The environment features include all the input features (except speed features) described above for the training of the learning-based critic as described in Figure 3. When the input features are encoded into the embedding 515, they have less dimensions. Such dimension compression can speed up the training and inference of the learning-based critic. Then, the decoder 506 can recover speed features from the embedding layer 515 based on the environment features as part of the process of training the encoder 501.

The embedding 515 is a neural network layer with a relatively low-dimension space, which can make machine learning easier on large inputs like sparse vectors.

In one embodiment, the encoder-decoder model used to train the encoder 501 above is a gated recurrent unit (GRU)-Encoder-Decoder (GRU-ED) model. Both the encoder 501 and the decoder 506 can be a recurrent neural network.

In Figure 5A, each of the RNN cells 503, 505, and 507 is a GRU that has two inputs, a hidden state and an input state. Trajectories 506, 508 and 510 are fed into the encoder 501 in sequence. In addition, goal features $fea_g$ 504 are passed to a linear layer 502, and mapped to an initial hidden state of the linear layer 502. As shown, the input sequence of the encoder 501 is in a reversed order, which makes the embedding 515 focus on features in the nearest time slot.

Figure 5B shows an example of the learning-based critic, which includes the encoder 501, the embedding layer 517, and a similarity network 527.

During inference, the pre-trained encoder 501 can generate the demonstration embedding 515, from which trajectories and/speed plans can be recovered given a particular environment. These trajectories and/or speed features may not raw trajectories and/or speed plans recorded by a record files. Rather, they are trajectories and/or speed plans inferred by the learning-based critic based on its training.

The inferred trajectories and/or speed plans can be fed into the similarity network 527, together with trajectories and/speed plans generated by a motion planner to be evaluated by the learning-based critic.

The similarity network 527 can be a multi-layer perceptron (MLP) model or a RNN model, and can be trained using the dataset that includes both human driving trajectories and random trajectories generated by the AT-sampler. The trained similarity network 527 can be used to measure similarity between a demonstration trajectory from the embedding layer 515 and a trajectory 512 generated by a motion planner.

Figure 6 illustrates an example of an autonomous driving simulation platform for some embodiments of the invention.

The safety and reliability of an ADV are guaranteed by massive functional and performance tests, which are expensive and time consuming if these tests were conducted using physical vehicles on roads. A simulation platform 601 shown in this figure can be used to perform these tasks less costly and more efficiently.

In one embodiment, the example simulation platform 601 includes a dynamic model 602 of an ADV, a game-engine based simulator 619 and a record file player 621. The game-engine based simulator 619 can provide a 3D virtual world where sensors can perceive and provide precise ground truth data for every piece of an environment. The record file player 621 can replay record files recorded in the real world for use in testing the functions and performance of various modules of the dynamic model 602.

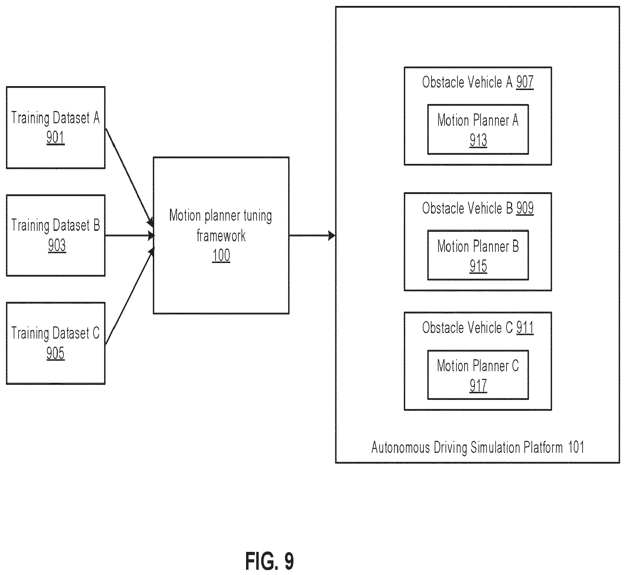

In one embodiment, the ADV dynamic model 602 can be a virtual vehicle that includes a number of core software modules, including a perception module 605, a prediction module 605, a planning module 609, a control module 609, a speed planner module 613, a CAN Bus module 611, a speed planner module 613, and a localization module 615. The functions of these modules are described in detail in Figures 9 and 11.

As further shown, the simulation platform 601 can include a guardian module 623, which is a safety module that performs the function of an action center and intervenes when a monitor 625 detects a failure. When all modules work as expected, the guardian module 623 allows the flow of control to work normally. When a crash in one of the modules is detected by the monitor 625, the guardian module 623 can prevent control signals from reaching the CAN Bus 611 and can bring the ADV dynamic model 602 to a stop.

The simulation platform 601 can include a human machine interface (HMI) 627, which is a module for viewing the status of the dynamic model 602, and controlling the dynamic model 602 in real time.

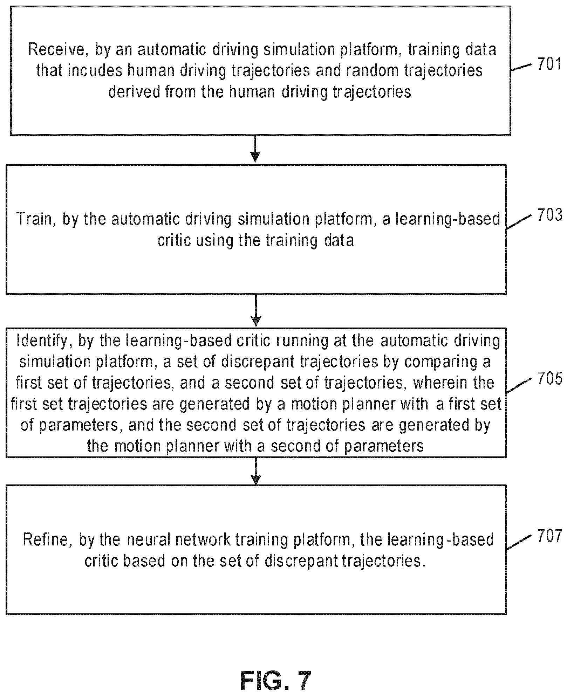

Figure 7 is a flow chart illustrating a process of training a learning-based critic for tuning a motion planner of an ADV according to one embodiment. The process may be performed by processing logic which may include software, hardware, or a combination thereof. For example, the process may be performed by various components and services in the autonomous simulation platform described in Figure 6.

Referring to Figure 7, in operation 701, the processing logic receives training data that incudes human driving trajectories and random trajectories derived from the human driving trajectories. In operation 703, the processing logic trains a learning-based critic using the training data. In operation 705, the processing logic identifies a set of discrepant trajectories by comparing a first set of trajectories, and a second set of trajectories. The first set trajectories are generated by a motion planner with a first set of parameters, and the second set of trajectories are generated by the motion planner with a second of parameters. In operation 707, the processing logic refines the learning-based critic based on the set of discrepant trajectories.

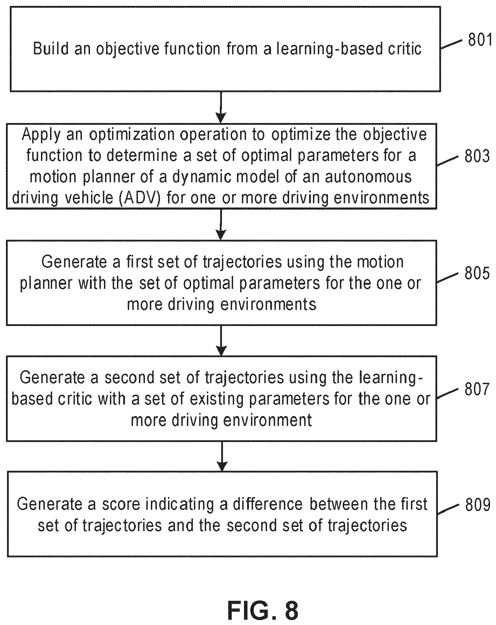

Figure 8 a flow chart illustrating a process of tuning a motion planner of an autonomous driving vehicle (ADV) according to one embodiment. The process may be performed by processing logic which may include software, hardware, or a combination thereof. For example, the process may be performed by various components and services in the autonomous simulation platform described in Figure 6.

Referring to Figure 8, in operation 801, the processing logic building an objective function from a learning-based critic. In operation 803, the processing logic applies an optimization operation to optimize the objective function to determine a set of optimal parameters for a motion planner of a dynamic model of an autonomous driving vehicle (ADV) for one or more driving environments. In operation 805, the processing logic generates a first set of trajectories using the motion planner with the set of optimal parameters for the one or more driving environments. In operation 807, the processing logic generates a second set of trajectories using the learning-based critic with a set of existing parameters for the one or more driving environment. In operation 809, the processing logic generates a score indicating a difference between the first set of trajectories and the second set of trajectories.

Simulation Obstacle Vehicles

Figure 9 illustrates a system for creating simulation obstacle vehicles with human-like driving styles in a simulation platform according to one embodiment.

As shown in Figure 9, the motion planner tuning framework 100 as described above can be used to create multiple obstacle vehicles in a simulation platform, such as the autonomous driving simulation platform 601.

In one embodiment, training data with different driving styles can be provided to the motion planner training tuning platform 100 to tune different motion planners.

For example, training dataset A 901 can be data representing an aggressive driving style, training dataset C 905 can be data representing a conservative driving style, and training dataset B 903 can be data representing a medium driving style, which is neither aggressive nor conservative.

The motion planner tuning framework 100 can include a training phase 105, a tuning phase 107, and an evaluation phase 109, each phase including a block of operations. Each set of training datasets 901, 903, and 905 can be provided to the motion planner tuning framework 100, for use in training a separate learning-based critic. The trained learning-based critic can be used to tune a motion planner such that the motion planner would have the driving style in the corresponding set of training data.

The process of tuning a motion planner is described in Figures 1-9 above, and the details of the process are not repeated here.

In one embodiment, three motion planners 913, 915 and 917 can be tuned using the motion planner turning framework 100, each with a different driving style, but each would behave in a human-like manner. Each of the tuned motion planners 913, 915, and 917 can be deployed to a dynamic model (e.g., simulation obstacle vehicle), which can run in a 3D virtual driving environment of the autonomous driving simulation platform 101.

As shown in Figure 9, the autonomous driving simulation platform 101 includes three vehicle obstacles 907, 909 and 911 with the three tuned motion planners 913, 915, and 917 respectively. When a dynamic model representing an ADV is simulated in the autonomous driving simulation platform 101, each of the obstacles 913, 915, and 917 would behave like a vehicle driven by a human driver. Thus, any of the obstacle vehicles 913, 915, and 917 would slow down if the ADV being simulated cuts right in front that vehicle obstacle, as a vehicle driven by a human driver would do in real life.

In an embodiment, with the system described in this figure, different types of simulation environments can be created using appropriate training data. For example, if an aggressive driving environment is needed, multiple sets of training data, each with a different level of aggressiveness can be collected or created, for use in training motion planners with aggressive driving behaviors. Similarly, if a conservative simulation environment is needed, multiple data sets, each with a different level of conservativeness, can be used to train motion planners with conservative driving behaviors.

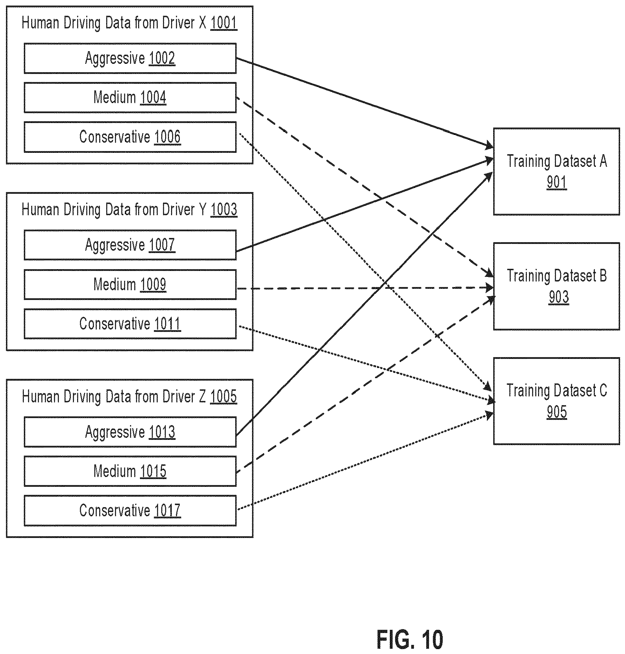

Figure 10 illustrates a method of creating training data of different driving styles according to one embodiment.

In one embodiment, the training data sets 901, 903, and 905 can be created from human driving datasets from multiple human drivers, for example, driver X 1001, driver Y 1003, and driver Z. Each driver may have a different driving style. But regardless of the driving style of a driver, the dataset collected from that driver may have data of different driving behaviors.

For example, driver X is an aggressive driver, driver Y is a medium driver, and driver Z is a conservative driver. However, the dataset 1001 collected from driver X may include data of all types of driving behaviors, for example, aggressive data 1002, medium data 1004, and conservative data 1006. The dataset 1003 collected from driver Y can also include different types of data, for example, aggressive data 1007, medium data 1009, and conservative data 1011. Similarly, the dataset 1005 collected from driver Z also includes different types of data, for example, aggressive data 1013, medium data 1015, and conservative data 1017.

However, the dataset 1001 can be predominantly aggressive data, the dataset 1003 can be predominantly medium data, and the dataset 1005 can be predominantly conservative data.

In one embodiment, the training platform used in the training phase 105 of the motion planner tuning framework 100 can be used to aggregate the same types of data from each of the training datasets 1001, 1003, and 1005 to form the datasets 901, 903, and 905.

As used herein, each dataset includes trajectory information from one or more record files, and includes information for acceleration, speed, heading, curvature at each reference point on a trajectory of a human-driven vehicle.

In one embodiment, a ruled-based classification algorithm can be used to classify the collected human driving data into different categories based on map information, perception information, and/or traffic rules. The ruled-based classification algorithm can examine a driver's driving speed and lane changing behavior to determine whether a particular driving behavior is aggressive, medium, or conservative. If the driver's speed exceeds the speed limit by 10 or more miles per hour, the driving behavior is classified as aggressive. If the driver's speed is below the speed limit by 10 or more miles per hour, that driving behavior is classified as conservative. If the driver's speed does not exceed the speed limit by 5 miles per hour, and does not fall below the speed limit by 5 miles per hour, that driving behavior is classified as medium.

With regard to lane change behaviors, the rule-based classification algorithm determines whether a driving behavior is aggressive, medium, or conservative based on a distance between the vehicle driven by the driver and any vehicle in the destination lane. If after a lane change, the driver's vehicle is within a predetermined distance (e.g., 2 meters) of either a vehicle behind it or in front of it, that lane changing behavior is aggressive driver. If the distance is over 10 meters, that lane changing behavior is conservative. If the distance is between 2 meters and 10 meters, that lane changing behavior is a medium driver.

Figure 11 is a block diagram illustrating a process flow of an automatic parameter tuning framework 1101 according to one embodiment. The automatic parameter tuning framework 1101 can be used by the motion planner tuning framework 101 to tune a motion planner.

The automatic parameter tuning framework 1101 includes a tuner component 1110, a simulation service 1120, and a cost computation service 1130. To achieve high efficiency, the tuner component 1110 supports a parallel evaluation process by spawning multiple worker threads to sample different sets of parameter values, for a selected ADV type, at the same time. The sampling method can be customized based upon a parameter optimizer 1112 and a sampling policy. The parameter optimizer 1112 can be a Bayesian Global Optimizer, which can utilize multiple probability models for approximating the objective functions, e.g., Gaussian Process Regress (GPR) and Tree-structured Parzen Estimator (TPE).

The parameters to be sampled by the turner component 1101 are described in Figure 7. The statistical performance metrics calculated by the open space planner profiling tool 126 (e.g., a mean, a 95 percentile, and a range in values of each parameter/feature) can be used in the selection of pertinent parameters values to improve tuning efficiency.

For example, if the range of values for a parameter, e.g., trajectory latency, is within a particular range, the tuner component 1110 would not select values for the parameter that is not in the particular range when generating the multiple sets of parameters 1115.

Each set of the sets of parameters 1115 can be combined with a pre-selected set of training scenarios 1122 to generate tasks, each of which is a unique combination of one set of parameter values 1115 and one training scenario 1122.

A task distribution 1124 logic can manage the tasks, and sends requests to the simulation service 1120 to execute the tasks. Since the tasks are independent of each other, another round of efficiency boost is accomplished in the simulation service 1120 by running all tasks in parallel and returning the execution records to the cost computation service 1130 separately.

Upon receipt of each execution record, the cost computation service 1130 calculates a score 1120 for the task. A weighted average score 1135 is also obtained for the specific set of parameter values 1115 across all training scenarios 1122. The average score is fed back to the tuner component 1110 for optimization in a next iteration by parameter optimizer 1112.

In an embodiment, for each tunable parameter in a set of sampled new parameters 1115, parameter optimizer 1112 selects an initial ("first") value. The initial value for each tunable parameter 1115 can be randomly selected within a value range space for the tunable parameter.

The parameter optimizer 1112 iterates the data flow for a predetermined fixed number of times. Each iteration produces a single weighted score 1135 that is used as an objective by parameter optimizer 1112 to modify the sampled parameters 1115 for a next iteration of the optimizer. When the fixed number of iterations have been performed, the parameter optimizer 1112 determines the optimal value for each tunable parameter in the plurality of tunable parameters 1115. In subsequent iterations, parameter optimizer 1112 can modify the values of the plurality of tunable parameters at each iteration of the optimization operations described herein. In an embodiment, parameter optimizer 1112 can use the weighted score 1135 to modify the values of the plurality of tunable parameters for a next iteration of the parameter optimizer 1112.

Parameter optimizer 1112 can be configured to optimize a predetermined fixed number of sets of tunable parameters 1115 (also termed, "sampled new parameters 1115"), such as sets of sampled new parameters 1115A.. 1115C. Each set of sampled new parameters 1115A.. 1115C can be optimized simultaneously, in parallel, and independently from one another. The predetermined fixed number of optimizer iterations for each of the sampled new parameters 1115A.. 1115C can be the same number of optimizer iterations, such that when each set of sampled new parameters 1115A.. 1115C complete their fixed number of optimization iterations, the parameter optimizer 1112 can select a best one set of the sampled new parameters 1115A..1115C using the weighted score 1135A..1135C of each set of the sampled new parameters 1115A.. 1115C at the completion of the fixed number of iterations.

The cost computation service 1130 can include a database of training scenarios 1122. Training scenarios 1122 can include several thousand different driving scenarios. In an embodiment, the plurality of driving scenarios in an open space, e.g., a left turn at low speed in a parking lot, and a right turn at low speed in the parking lot.

The task distribution 1124 manages and schedules the simulations 1125A..1125C for each of a set of selected driving scenarios 1122 for each of the sets of sampled new parameters 1115A.. 1115C. For example, if there are 3 sets of sampled new parameters, and 10 selected driving scenarios, the total of numbers of scheduled simulations can be 40.

For each of the 40 simulations, the simulation service 1120 can perform a simulation task 1125, which can include simultaneous operations on multiple threads. For each simulation task, the cost computation service 1130 can generate a score 1132 measuring the performance of the ADV simulation 1125 in light of the performance metrics described in Figure 7. Thus, for sampled new parameter set 1115A, the cost computation service 1130 can provide a score computation for each of the simulations 1125A1..1125A14, with scores 1132A1..1132A14. The cost computation service 1130 can also provide a single weighted score 1135A representing performance of the ADV using values of the set of sampled new parameters 1115A of the simulated ADV for all the 40 simulations.

In an embodiment, the weights used to generate the weighted score 1135 reflect higher, or lower, relative importance of certain metrics in the plurality of metrics used to generate a score computation 1132. For example, a station endpoint error of the driving scenario may be weighted higher than an average speed error. Safety errors may be weighted higher than passenger comfort errors, passenger comfort errors may be weighted higher than frequency of usage of the controls, such as braking, steering, or throttle.

The cost computation service 1130 provides weighted scores 1135A..1135C to parameter optimizer 1112, which can use the weighted score 1135A to modify the sampled new parameters 1115A for a next iteration ("repetition") of the optimizer to find optimal values for the sampled new parameters 1115A. Similarly, parameter optimizer 1112 can use weighted score 1135B to modify the sampled new parameters 1115B for a next iteration of the optimizer to find optimal values for the sampled new parameters 1115B. Additionally, parameter optimizer 1112 can use weighted score 1135C to modify the sampled new parameters 1115C for a next iteration of the parameter optimizer 1112 to find optimized values for the sampled new parameters 1115C.

In an embodiment, at the end of a configurable, predetermined fixed number of iterations of the parameter optimizer 1112, a best set of new sampled parameters 1115 can be selected from the three (3) sets of sampled new parameters 1115A..1115C, and the best set of sampled new parameters 1115 can be downloaded to a physical, real-world ADV having the ADV type for the sampled new parameters 1115A..1115C, to navigate the ADV having the ADV type. In an embodiment, each of sampled new parameters 1115A..1115C can be for a different ADV type. At the completion of the fixed number of iterations of the parameter optimizer 1112, each set of sampled new parameters is optimized. Each of the optimized sample new parameter sets 1115A..1115C can be downloaded to a physical, real-world ADV of the ADV type for the sample new parameter set, and each ADV of the physical real-world ADVs can be navigated using the values of the optimized set of sampled new parameters for the ADV type.

For each set of sampled new parameters 1115, a best set of values for the sampled new parameter set can be one or more of: (1) the values of the parameters in the set of sampled new parameters 1115 at the end of the fixed number of iterations of the parameter optimizer 1112, (2) the values of the set of parameters in the sampled new parameters 1115 at the end of the fixed number of iterations, as would be modified by the parameter optimizer 1112 if there were to be one or more iteration of the parameter optimizer 1112, or (3) the values of the set of sampled new parameters 1115 after an iteration of the parameter optimizer 1112, if the difference between the weighted score 1135 of the current iteration is less than the weighted score 1135 of a preceding iteration of the parameter optimizer 1112 by a predetermined threshold amount. In an embodiment wherein the sampled new parameter sets 1115A.. 1115C all relate to a same type of ADV, then the best values among sampled new parameter sets 1115A..1115C can be the sampled new parameter set 1115 having the best weighted score 1135 after the end of optimizing each of the sampled new parameter sets 1115A.. 1115C.

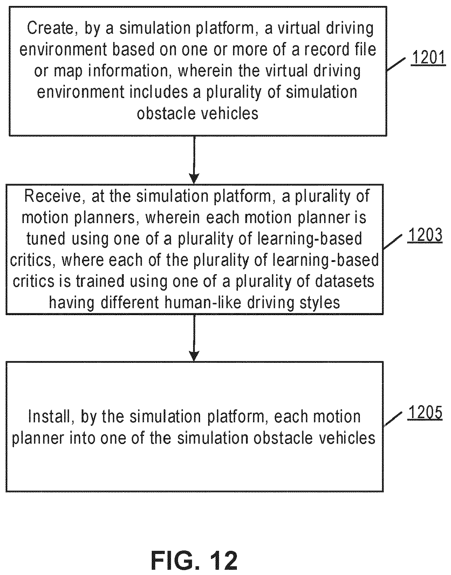

Figure 12 is a flow chart illustrating a process of creating a simulation environment for simulating autonomous driving vehicles (ADV) according to one embodiment. The process may be performed by processing logic which may include software, hardware, or a combination thereof. For example, the process may be performed by various components and services in the motion planner tuning frame described in Figure 1.

Referring to Figure 12, in operation 1201, the processing logic creates a virtual driving environment based on one or more of a record file or map information, wherein the virtual driving environment includes a plurality of simulation obstacle vehicles. In operation 1203, the processing logic receives a plurality of motion planners, wherein each motion planner is tuned using one of a plurality of learning-based critics, wherein each of the plurality of learning-based critics is trained using one of a plurality of datasets having different human-like driving styles. In operation 1205, the processing logic installs each motion planner into one of the simulation obstacle vehicles.

Automatic Driving Vehicle

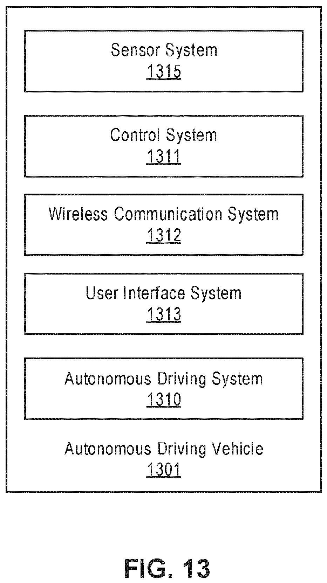

Figure 13 is a block diagram illustrating an autonomous driving vehicle according to one embodiment. Referring to Figure 13, autonomous driving vehicle 1301 may be communicatively coupled to one or more servers over a network, which may be any type of networks such as a local area network (LAN), a wide area network (WAN) such as the Internet, a cellular network, a satellite network, or a combination thereof, wired or wireless. The server(s) may be any kind of servers or a cluster of servers, such as Web or cloud servers, application servers, backend servers, or a combination thereof. A server may be a data analytics server, a content server, a traffic information server, a map and point of interest (MPOI) server, or a location server, etc.

An autonomous driving vehicle refers to a vehicle that can be configured to in an autonomous mode in which the vehicle navigates through an environment with little or no input from a driver. Such an autonomous driving vehicle can include a sensor system having one or more sensors that are configured to detect information about the environment in which the vehicle operates. The vehicle and its associated controller(s) use the detected information to navigate through the environment. Autonomous driving vehicle 1301 can operate in a manual mode, a full autonomous mode, or a partial autonomous mode.

In one embodiment, autonomous driving vehicle 1301 includes, but is not limited to, autonomous driving system (ADS) 1310, vehicle control system 1311, wireless communication system 1312, user interface system 1313, and sensor system 1315. Autonomous driving vehicle 1301 may further include certain common components included in ordinary vehicles, such as, an engine, wheels, steering wheel, transmission, etc., which may be controlled by vehicle control system 1311 and/or ADS 1310 using a variety of communication signals and/or commands, such as, for example, acceleration signals or commands, deceleration signals or commands, steering signals or commands, braking signals or commands, etc.

Components 1310-1315 may be communicatively coupled to each other via an interconnect, a bus, a network, or a combination thereof. For example, components 1310-1315 may be communicatively coupled to each other via a controller area network (CAN) bus. A CAN bus is a vehicle bus standard designed to allow microcontrollers and devices to communicate with each other in applications without a host computer. It is a message-based protocol, designed originally for multiplex electrical wiring within automobiles, but is also used in many other contexts.

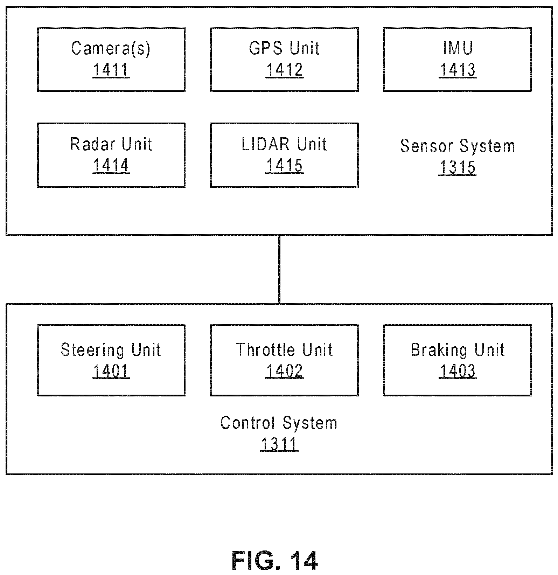

Referring now to Figure 14, in one embodiment, sensor system 1315 includes, but it is not limited to, one or more cameras 1411, global positioning system (GPS) unit 1412, inertial measurement unit (IMU) 1413, radar unit 1414, and a light detection and range (LIDAR) unit 1415. GPS system 1412 may include a transceiver operable to provide information regarding the position of the autonomous driving vehicle. IMU unit 1413 may sense position and orientation changes of the autonomous driving vehicle based on inertial acceleration. Radar unit 1414 may represent a system that utilizes radio signals to sense objects within the local environment of the autonomous driving vehicle. In some embodiments, in addition to sensing objects, radar unit 1414 may additionally sense the speed and/or heading of the objects. LIDAR unit 1415 may sense objects in the environment in which the autonomous driving vehicle is located using lasers. LIDAR unit 1415 could include one or more laser sources, a laser scanner, and one or more detectors, among other system components. Cameras 1411 may include one or more devices to capture images of the environment surrounding the autonomous driving vehicle. Cameras 1411 may be still cameras and/or video cameras. A camera may be mechanically movable, for example, by mounting the camera on a rotating and/or tilting a platform.

Sensor system 1315 may further include other sensors, such as, a sonar sensor, an infrared sensor, a steering sensor, a throttle sensor, a braking sensor, and an audio sensor (e.g., microphone). An audio sensor may be configured to capture sound from the environment surrounding the autonomous driving vehicle. A steering sensor may be configured to sense the steering angle of a steering wheel, wheels of the vehicle, or a combination thereof. A throttle sensor and a braking sensor sense the throttle position and braking position of the vehicle, respectively. In some situations, a throttle sensor and a braking sensor may be integrated as an integrated throttle/braking sensor.

In one embodiment, vehicle control system 1311 includes, but is not limited to, steering unit 1401, throttle unit 1402 (also referred to as an acceleration unit), and braking unit 1403. Steering unit 1401 is to adjust the direction or heading of the vehicle. Throttle unit 1402 is to control the speed of the motor or engine that in turn controls the speed and acceleration of the vehicle. Braking unit 1403 is to decelerate the vehicle by providing friction to slow the wheels or tires of the vehicle. Note that the components as shown in Figure 14 may be implemented in hardware, software, or a combination thereof.

Referring back to Figure 13, wireless communication system 1312 is to allow communication between autonomous driving vehicle 1301 and external systems, such as devices, sensors, other vehicles, etc. For example, wireless communication system 1312 can wirelessly communicate with one or more devices directly or via a communication network. Wireless communication system 1312 can use any cellular communication network or a wireless local area network (WLAN), e.g., using WiFi to communicate with another component or system. Wireless communication system 1312 could communicate directly with a device (e.g., a mobile device of a passenger, a display device, a speaker within vehicle 1301), for example, using an infrared link, Bluetooth, etc. User interface system 1313 may be part of peripheral devices implemented within vehicle 1301 including, for example, a keyboard, a touch screen display device, a microphone, and a speaker, etc.

Some or all of the functions of autonomous driving vehicle 1301 may be controlled or managed by ADS 1310, especially when operating in an autonomous driving mode. ADS 1310 includes the necessary hardware (e.g., processor(s), memory, storage) and software (e.g., operating system, planning and routing programs) to receive information from sensor system 1315, control system 1311, wireless communication system 1312, and/or user interface system 1313, process the received information, plan a route or path from a starting point to a destination point, and then drive vehicle 1301 based on the planning and control information. Alternatively, ADS 1310 may be integrated with vehicle control system 1311.

For example, a user as a passenger may specify a starting location and a destination of a trip, for example, via a user interface. ADS 1310 obtains the trip related data. For example, ADS 1310 may obtain location and route data from an MPOI server. The location server provides location services and the MPOI server provides map services and the POIs of certain locations. Alternatively, such location and MPOI information may be cached locally in a persistent storage device of ADS 1310.

While autonomous driving vehicle 1301 is moving along the route, ADS 1310 may also obtain real-time traffic information from a traffic information system or server (TIS). Note that the servers may be operated by a third party entity. Alternatively, the functionalities of the servers may be integrated with ADS 1310. Based on the real-time traffic information, MPOI information, and location information, as well as real-time local environment data detected or sensed by sensor system 1315 (e.g., obstacles, objects, nearby vehicles), ADS 1310 can plan an optimal route and drive vehicle 1301, for example, via control system 1311, according to the planned route to reach the specified destination safely and efficiently.

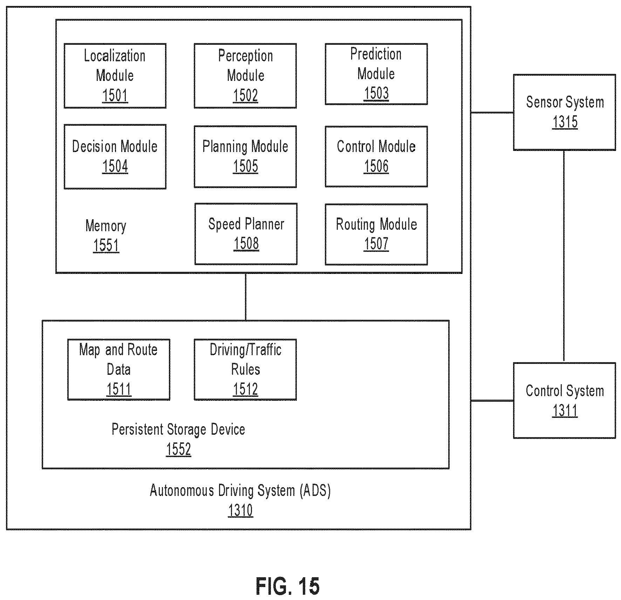

Figure 15 is a block diagram illustrating an example of the autonomous driving system 1310 according to one embodiment. The autonomous driving system 1310 may be implemented as a part of autonomous driving vehicle 1301 of Figure 13 including, but is not limited to, ADS 1310, control system 1311, and sensor system 1315.

Referring to Figure 15, ADS 1310 includes, but is not limited to, localization module 1501, perception module 1502, prediction module 1503, decision module 1504, planning module 1505, control module 1506, routing module 1507, speed planner module 1508. These modules and the modules described in Figure 6 perform similar functions.

Some or all of modules 1501-1508 may be implemented in software, hardware, or a combination thereof. For example, these modules may be installed in persistent storage device 1552, loaded into memory 1551, and executed by one or more processors (not shown). Note that some or all of these modules may be communicatively coupled to or integrated with some or all modules of vehicle control system 1311 of Figure 13. Some of modules 1501-1508 may be integrated together as an integrated module.

Localization module 1501 determines a current location of autonomous driving vehicle 1301 (e.g., leveraging GPS unit 1412) and manages any data related to a trip or route of a user. Localization module 1501 (also referred to as a map and route module) manages any data related to a trip or route of a user. A user may log in and specify a starting location and a destination of a trip, for example, via a user interface. Localization module 1501 communicates with other components of autonomous driving vehicle 1301, such as map and route data 1511, to obtain the trip related data. For example, localization module 1501 may obtain location and route data from a location server and a map and POI (MPOI) server. A location server provides location services and an MPOI server provides map services and the POIs of certain locations, which may be cached as part of map and route data 1511. While autonomous driving vehicle 1301 is moving along the route, localization module 1501 may also obtain real-time traffic information from a traffic information system or server.

Based on the sensor data provided by sensor system 1315 and localization information obtained by localization module 1501, a perception of the surrounding environment is determined by perception module 1502. The perception information may represent what an ordinary driver would perceive surrounding a vehicle in which the driver is driving. The perception can include the lane configuration, traffic light signals, a relative position of another vehicle, a pedestrian, a building, crosswalk, or other traffic related signs (e.g., stop signs, yield signs), etc., for example, in a form of an object. The lane configuration includes information describing a lane or lanes, such as, for example, a shape of the lane (e.g., straight or curvature), a width of the lane, how many lanes in a road, one-way or two-way lane, merging or splitting lanes, exiting lane, etc.

Perception module 1502 may include a computer vision system or functionalities of a computer vision system to process and analyze images captured by one or more cameras in order to identify objects and/or features in the environment of autonomous driving vehicle. The objects can include traffic signals, road way boundaries, other vehicles, pedestrians, and/or obstacles, etc. The computer vision system may use an object recognition algorithm, video tracking, and other computer vision techniques. In some embodiments, the computer vision system can map an environment, track objects, and estimate the speed of objects, etc. Perception module 1502 can also detect objects based on other sensors data provided by other sensors such as a radar and/or LIDAR.

For each of the objects, prediction module 1503 predicts what the object will behave under the circumstances. The prediction is performed based on the perception data perceiving the driving environment at the point in time in view of a set of map/rout information 1511 and traffic rules 1512. For example, if the object is a vehicle at an opposing direction and the current driving environment includes an intersection, prediction module 1503 will predict whether the vehicle will likely move straight forward or make a turn. If the perception data indicates that the intersection has no traffic light, prediction module 1503 may predict that the vehicle may have to fully stop prior to enter the intersection. If the perception data indicates that the vehicle is currently at a left-turn only lane or a right-turn only lane, prediction module 1503 may predict that the vehicle will more likely make a left turn or right turn respectively.

For each of the objects, decision module 1504 makes a decision regarding how to handle the object. For example, for a particular object (e.g., another vehicle in a crossing route) as well as its metadata describing the object (e.g., a speed, direction, turning angle), decision module 1504 decides how to encounter the object (e.g., overtake, yield, stop, pass). Decision module 1504 may make such decisions according to a set of rules such as traffic rules or driving rules 1512, which may be stored in persistent storage device 1552.

Routing module 1507 is configured to provide one or more routes or paths from a starting point to a destination point. For a given trip from a start location to a destination location, for example, received from a user, routing module 1507 obtains route and map information 1511 and determines all possible routes or paths from the starting location to reach the destination location. Routing module 1507 may generate a reference line in a form of a topographic map for each of the routes it determines from the starting location to reach the destination location. A reference line refers to an ideal route or path without any interference from others such as other vehicles, obstacles, or traffic condition. That is, if there is no other vehicle, pedestrians, or obstacles on the road, an ADV should exactly or closely follows the reference line. The topographic maps are then provided to decision module 1504 and/or planning module 1505. Decision module 1504 and/or planning module 1505 examine all of the possible routes to select and modify one of the most optimal routes in view of other data provided by other modules such as traffic conditions from localization module 1501, driving environment perceived by perception module 1502, and traffic condition predicted by prediction module 1503. The actual path or route for controlling the ADV may be close to or different from the reference line provided by routing module 1507 dependent upon the specific driving environment at the point in time.

Based on a decision for each of the objects perceived, planning module 1505 plans a path or route for the autonomous driving vehicle, as well as driving parameters (e.g., distance, speed, and/or turning angle), using a reference line provided by routing module 1507 as a basis. That is, for a given object, decision module 1504 decides what to do with the object, while planning module 1505 determines how to do it. For example, for a given object, decision module 1504 may decide to pass the object, while planning module 1505 may determine whether to pass on the left side or right side of the object. Planning and control data is generated by planning module 1505 including information describing how vehicle 1501 would move in a next moving cycle (e.g., next route/path segment). For example, the planning and control data may instruct vehicle 1312 to move 10 meters at a speed of 30 miles per hour (mph), then change to a right lane at the speed of 25 mph.

Speed planner 1508 can be part of planning module 1505 or a separate module. Given a planned trajectory, speed planner 1508 guides the ADV to traverse along the planned path with a sequence of proper speeds $v = [v_i ...], i \in [0, N]$, where $v_i = ds_i/dt$ and $ds_i$ is the traverse distance along the path at $t = i$ and $dt$ is the sampling time.

Based on the planning and control data, control module 1506 controls and drives the autonomous driving vehicle, by sending proper commands or signals to vehicle control system 1311, according to a route or path defined by the planning and control data. The planning and control data include sufficient information to drive the vehicle from a first point to a second point of a route or path using appropriate vehicle settings or driving parameters (e.g., throttle, braking, steering commands) at different points in time along the path or route.

In one embodiment, the planning phase is performed in a number of planning cycles, also referred to as driving cycles, such as, for example, in every time interval of 100 milliseconds (ms). For each of the planning cycles or driving cycles, one or more control commands will be issued based on the planning and control data. That is, for every 100 ms, planning module 1505 plans a next route segment or path segment, for example, including a target position and the time required for the ADV to reach the target position. Alternatively, planning module 1505 may further specify the specific speed, direction, and/or steering angle, etc. In one embodiment, planning module 1505 plans a route segment or path segment for the next predetermined period of time such as 5 seconds. For each planning cycle, planning module 1505 plans a target position for the current cycle (e.g., next 5 seconds) based on a target position planned in a previous cycle. Control module 1506 then generates one or more control commands (e.g., throttle, brake, steering control commands) based on the planning and control data of the current cycle.

Note that decision module 1504 and planning module 1505 may be integrated as an integrated module. Decision module 1504/planning module 1505 may include a navigation system or functionalities of a navigation system to determine a driving path for the autonomous driving vehicle. For example, the navigation system may determine a series of speeds and directional headings to affect movement of the autonomous driving vehicle along a path that substantially avoids perceived obstacles while generally advancing the autonomous driving vehicle along a roadway-based path leading to an ultimate destination. The destination may be set according to user inputs via user interface system 1313. The navigation system may update the driving path dynamically while the autonomous driving vehicle is in operation. The navigation system can incorporate data from a GPS system and one or more maps so as to determine the driving path for the autonomous driving vehicle.

According to one embodiment, a system architecture of an autonomous driving system as described above includes, but it is not limited to, an application layer, a planning and control (PNC) layer, a perception layer, a device driver layer, a firmware layer, and a hardware layer. The application layer may include user interface or configuration application that interacts with users or passengers of an autonomous driving vehicle, such as, for example, functionalities associated with user interface system 1313. The PNC layer may include functionalities of at least planning module 1505 and control module 1506. The perception layer may include functionalities of at least perception module 1502. In one embodiment, there is an additional layer including the functionalities of prediction module 1503 and/or decision module 1504. Alternatively, such functionalities may be included in the PNC layer and/or the perception layer. The firmware layer may represent at least the functionality of sensor system 1315, which may be implemented in a form of a field programmable gate array (FPGA). The hardware layer may represent the hardware of the autonomous driving vehicle such as control system 1311. The application layer, PNC layer, and perception layer can communicate with the firmware layer and hardware layer via the device driver layer.

Note that some or all of the components as shown and described above may be implemented in software, hardware, or a combination thereof. For example, such components can be implemented as software installed and stored in a persistent storage device, which can be loaded and executed in a memory by a processor (not shown) to carry out the processes or operations described throughout this application. Alternatively, such components can be implemented as executable code programmed or embedded into dedicated hardware such as an integrated circuit (e.g., an application specific IC or ASIC), a digital signal processor (DSP), or a field programmable gate array (FPGA), which can be accessed via a corresponding driver and/or operating system from an application. Furthermore, such components can be implemented as specific hardware logic in a processor or processor core as part of an instruction set accessible by a software component via one or more specific instructions.

Some portions of the preceding detailed descriptions have been presented in terms of algorithms and symbolic representations of operations on data bits within a computer memory. These algorithmic descriptions and representations are the ways used by those skilled in the data processing arts to most effectively convey the substance of their work to others skilled in the art. An algorithm is here, and generally, conceived to be a self-consistent sequence of operations leading to a desired result. The operations are those requiring physical manipulations of physical quantities.

It should be borne in mind, however, that all of these and similar terms are to be associated with the appropriate physical quantities and are merely convenient labels applied to these quantities. Unless specifically stated otherwise as apparent from the above discussion, it is appreciated that throughout the description, discussions utilizing terms such as those set forth in the claims below, refer to the action and processes of a computer system, or similar electronic computing device, that manipulates and transforms data represented as physical (electronic) quantities within the computer system's registers and memories into other data similarly represented as physical quantities within the computer system memories or registers or other such information storage, transmission or display devices.

Embodiments of the disclosure also relate to an apparatus for performing the operations herein. Such a computer program is stored in a non-transitory computer readable medium. A machine-readable medium includes any mechanism for storing information in a form readable by a machine (e.g., a computer). For example, a machine-readable (e.g., computer-readable) medium includes a machine (e.g., a computer) readable storage medium (e.g., read only memory ("ROM"), random access memory ("RAM"), magnetic disk storage media, optical storage media, flash memory devices).

The processes or methods depicted in the preceding figures may be performed by processing logic that comprises hardware (e.g. circuitry, dedicated logic, etc.), software (e.g., embodied on a non-transitory computer readable medium), or a combination of both. Although the processes or methods are described above in terms of some sequential operations, it should be appreciated that some of the operations described may be performed in a different order. Moreover, some operations may be performed in parallel rather than sequentially.

Embodiments of the present disclosure are not described with reference to any particular programming language. It will be appreciated that a variety of programming languages may be used to implement the teachings of embodiments of the disclosure as described herein.

In the foregoing specification, embodiments of the disclosure have been described with reference to specific exemplary embodiments thereof. It will be evident that various modifications may be made thereto without departing from the broader spirit and scope of the disclosure as set forth in the following claims. The specification and drawings are, accordingly, to be regarded in an illustrative sense rather than a restrictive sense.

**Claims**

1. A computer-implemented method of creating a simulation environment for simulating autonomous driving vehicles (ADV), comprising:

   creating, by a simulation platform, a virtual driving environment based on one or more of a record file or map information, wherein the virtual driving environment includes a plurality of simulation obstacle vehicles;
   receiving, at the simulation platform, a plurality of motion planners, wherein each motion planner is tuned using one of a plurality of learning-based critics, wherein each of the plurality of learning-based critics is trained using one of a plurality of datasets having different human-like driving styles;
   installing, by the simulation platform, each motion planner into one of the simulation obstacle vehicles.

2. The method of claim 1, wherein each of the plurality of training datasets is created from human driving data collected from a plurality of human-driven vehicles.

3. The method of claim 2, wherein each of the plurality of training datasets includes data of a particular driving style from each of the plurality of human-driven vehicles.

4. The method of any of claims 1-3, wherein each learning-based critic and each motion planner has a same style as the corresponding training dataset.

5. The method of any of claims 1-4, wherein tuning the motion planner comprises:

receiving the training dataset, wherein the training dataset incudes human driving trajectories;
deriving random trajectories from the human driving trajectories;
training a learning-based critic using the human driving trajectories and the derived random trajectories;
identifying, by the learning-based, a set of discrepant trajectories by comparing a first set of trajectories, and a second set of trajectories, wherein the first set trajectories are generated by a motion planner with a first set of parameters, and the second set of trajectories are generated by the motion planner with a second of parameters;
refining the learning-based critic based on the set of discrepant trajectories.

6. The method of claim 5, wherein the first set of parameters of the motion planner are identified by the learning-based critic for one or more driving environments, and the second set of parameters are a set of existing parameters for the motion planner.

7. The method of claim 5, wherein the deriving of the random trajectory from the corresponding human driving trajectory comprises:

determining a starting point and an ending point of corresponding human driving trajectory;
varying one of one or more parameters of the corresponding human driving trajectory;
replacing a corresponding parameter of the human driving trajectory with the varied parameter to get the random trajectory,
especially, wherein the parameter is varied by giving the parameter a different value selected from a predetermined range.

8. The method of any of claims 1-7, wherein the learning-based critic includes an encoder and a similarity network, wherein each of the encoder and the similarity network is a neural network model,

especially, wherein each of the encoder and the similarity network is one of a recurrent neural network (RNN) or multi-layer perceptron (MLP) network,
especially, wherein the encoder is a RNN network, with each RNN cell being a gated recurrent unit (GRU).

9. The method of claim 8, wherein features extracted from the training data include speed features, path features, and obstacle features, wherein each feature is associated with a goal feature, wherein the goal feature is a map scenario related feature.

10. The method of claim 9, wherein the trained encoder is trained using the human driving trajectories, encodes speed features, path features, obstacle features, and associated goal features, and generates an embedding with trajectories that are different from the human driving trajectories,
wherein the similarity network is trained using the human driving trajectories and the random trajectories, and is to generate a score reflecting a difference between a trajectory generated by the motion planner and a corresponding trajectory from the embedding.

11. The method of any of claims 1-10, wherein the learning-based critic is trained using a loss function with an element for measuring similarity between trajectories.

12. A simulation platform for simulating autonomous driving vehicles (ADVs), comprising:

one or more microprocessor with a plurality of applications and services executed thereon, including a simulator, and a record file player;
wherein the simulator is to create a 3D virtual environment based on a record file played by the record file player;
wherein the 3D virtual environment includes a plurality of simulation obstacle vehicles, wherein each of the plurality of simulation obstacle vehicles is a dynamic model with a motion planner tuned using a learning-based critic trained using a dataset with a particular driving style.

13. The simulation platform of claim 12, further comprising:

a guardian module configured to control a flow of work in the simulation platform; and
a human machine interface (HMI) for viewing a status of an ADV being simulated in the 3D virtual environment, and controlling the ADV in the 3D virtual environment.

14. The simulation platform of claim 12 or 13, wherein the plurality of simulation obstacle vehicles have different driving styles.

15. The simulation platform of any of claims 12-14, wherein one or more obstacles in the record file are removed when the record file is used to create the 3D virtual environment; or

wherein each of the plurality of training datasets is created from human driving data collected from a plurality of human-driven vehicles.

FIG. 1

FIG. 2A        FIG. 2B        FIG. 2C

Table I

FEATURES FOR LEARNING-BASED CRITIC.

| Input Features | Dimensions |
|---|---|
| 301 $\mathtt{fea}_s$ | $v,\ a,\ j$ |
| 303 $\mathtt{fea}_p$ | $v_{\text{limit}},\ \alpha,\ \kappa$ |
| 305 $\mathtt{fea}_o$ | $o_{\text{type}},\ \hat{s},\ \hat{l},\ \hat{v}_s,\ \hat{a}_s,\ \hat{v}_l,\ \hat{a}_l,\ d_o$ |

FIG. 3

$$\mathcal{L}_{\text{critic}} = \sum_{\tau^* \in \mathcal{D}^*} f_{\text{critic},\varphi}\left(\tau^*\right) \tag{4a}$$

$$+ \sum_{\tau^* \in \mathcal{D}^*} \sum_{\tau \in \mathcal{D}} \left\| f_{\text{critic},\varphi}(\tau) - \mathtt{sim}(\tau, \tau^*) \right\| \tag{4b}$$

**FIG. 4A**

**FIG. 4B**

**FIG. 4C**

**FIG. 5A**

Encoder 501

502 503 505 507

Linear | GRU | GRU | ... | GRU

fea$_g$ | $\varepsilon_{fs}(\hat{c}_n)$ | $\varepsilon_{fs}(\hat{c}_{n-1})$ | ... | $\varepsilon_{fs}(\hat{c}_1)$

504 506 508 510

515

Decoder 506

517 519 521

$\varepsilon_s(\hat{c}_1)$ | $\varepsilon_s(\hat{c}_2)$ | ... | $\varepsilon_s(\hat{c}_n)$

GRU | GRU | ... | GRU

$\varepsilon_s(\hat{c}_1)$ | ... | $\varepsilon_s(\hat{c}_{n-1})$

523 525

**FIG. 5B**

Encoder 501

502 503 505 507

Linear | GRU | GRU | ... | GRU

fea$_g$ | $\varepsilon_{fs}(\hat{c}_n)$ | $\varepsilon_{fs}(\hat{c}_{n-1})$ | ... | $\varepsilon_{fs}(\hat{c}_1)$

504 506 508 510

515

Similarity network 527

$\varepsilon_s(r)$

512

Perception
Module
603

Prediction
Module
605

Planning
Module
607

Control
Module
609

Monitor
625

CANBus
Module
611

Speed
Planner
613

Localization
Module
615

ADV Dynamic Model 602

Game-Engine
Based Simulator
619

Record File Player
621

Guardian
623

HMI
627

Autonomous Driving Simulation Platform 601

FIG. 6

Receive, by an automatic driving simulation platform, training data that incudes human driving trajectories and random trajectories derived from the human driving trajectories — 701

Train, by the automatic driving simulation platform, a learning-based critic using the training data — 703

Identify, by the learning-based critic running at the automatic driving simulation platform, a set of discrepant trajectories by comparing a first set of trajectories, and a second set of trajectories, wherein the first set trajectories are generated by a motion planner with a first set of parameters, and the second set of trajectories are generated by the motion planner with a second of parameters — 705

Refine, by the neural network training platform, the learning-based critic based on the set of discrepant trajectories. — 707

FIG. 7

Build an objective function from a learning-based critic — 801

Apply an optimization operation to optimize the objective function to determine a set of optimal parameters for a motion planner of a dynamic model of an autonomous driving vehicle (ADV) for one or more driving environments — 803

Generate a first set of trajectories using the motion planner with the set of optimal parameters for the one or more driving environments — 805

Generate a second set of trajectories using the learning-based critic with a set of existing parameters for the one or more driving environment — 807

Generate a score indicating a difference between the first set of trajectories and the second set of trajectories — 809

FIG. 8

Training Dataset A
901

Training Dataset B
903

Training Dataset C
905

Motion planner tuning
framework
100

Obstacle Vehicle A 907

Motion Planner A
913

Obstacle Vehicle B 909

Motion Planner B
915

Obstacle Vehicle C 911

Motion Planner C
917

Autonomous Driving Simulation Platform 101

FIG. 9

FIG. 10

**FIG. 11**

Create, by a simulation platform, a virtual driving environment based on one or more of a record file or map information, wherein the virtual driving environment includes a plurality of simulation obstacle vehicles

1201

Receive, at the simulation platform, a plurality of motion planners, wherein each motion planner is tuned using one of a plurality of learning-based critics, where each of the plurality of learning-based critics is trained using one of a plurality of datasets having different human-like driving styles

1203

Install, by the simulation platform, each motion planner into one of the simulation obstacle vehicles

1205

FIG. 12

Sensor System
1315

Control System
1311

Wireless Communication System
1312

User Interface System
1313

Autonomous Driving System
1310

Autonomous Driving Vehicle
1301

FIG. 13

| Camera(s) 1411 | GPS Unit 1412 | IMU 1413 |
|---|---|---|
| Radar Unit 1414 | LIDAR Unit 1415 | Sensor System 1315 |

| Steering Unit 1401 | Throttle Unit 1402 | Braking Unit 1403 |
|---|---|---|

Control System
1311

**FIG. 14**

FIG. 15

Europäisches
Patentamt

European
Patent Office

Office européen
des brevets

# EUROPEAN SEARCH REPORT

Application Number

EP 22 21 4488

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br><br>Y | US 2020/074266 A1 (PEAKE MIGUEL ALEXANDER [US] ET AL) 5 March 2020 (2020-03-05)<br>* abstract *<br>* claim 1 *<br>* paragraph [0086] *<br>* paragraphs [0093] - [0094] *<br>* the whole document *<br>----- | 1-15<br><br>2-8 | INV.<br>G06F30/27<br>G06N3/0442<br>G06N3/0455<br>G06N3/092 |
| X<br><br><br><br><br><br><br><br><br><br><br><br>Y | PIETER ABBEEL ET AL: "Apprenticeship learning via inverse reinforcement learning",<br>PROCEEDINGS / TWENTY-FIRST INTERNATIONAL CONFERENCE ON MACHINE LEARNING : [JULY 4 - 8, 2004, BANFF, ALBERTA, CANADA] / ED. BY RUSSELL GREINER, INTERNATIONAL CONFERENCE ON MACHINE LEARNING <21, 2004, BANFF, ALBERTA>, CA,<br>4 July 2004 (2004-07-04), page 1,<br>XP058138576,<br>DOI: 10.1145/1015330.1015430<br>ISBN: 978-1-58113-838-2<br>* abstract; figure 5 *<br>* Section 5.2 *<br>* page 6, right-hand column, paragraph 2 *<br>* the whole document *<br>-----<br>-/-- | 1-15<br><br><br><br><br><br><br><br><br><br><br><br>2-4 | TECHNICAL FIELDS SEARCHED (IPC)<br><br>G06F<br>G06N |

The present search report has been drawn up for all claims

| Place of search | Date of completion of the search | Examiner |
|---|---|---|
| Munich | 12 May 2023 | Dapp, Wolfgang |

EPO FORM 1503 03.82 (P04C01)

## EUROPEAN SEARCH REPORT

Europäisches Patentamt
European Patent Office
Office européen des brevets

**Application Number**

EP 22 21 4488

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ZHOU JINYUN ET AL: "Exploring Imitation Learning for Autonomous Driving with Feedback Synthesizer and Differentiable Rasterization", 2021 IEEE/RSJ INTERNATIONAL CONFERENCE ON INTELLIGENT ROBOTS AND SYSTEMS (IROS), IEEE, 27 September 2021 (2021-09-27), pages 1450-1457, XP034051705, DOI: 10.1109/IROS51168.2021.9636795 [retrieved on 2021-12-03] | 1-15 | |
| Y | * abstract; figures 1-3 * <br> * Section III.A.2) * <br> * Section III.B * <br> * Section IV.B * <br> * page 3, paragraph 1 * <br> * the whole document * | 2,3,5-7 | |
| Y | RAUNAK BHATTACHARYYA ET AL: "Modeling Human Driving Behavior through Generative Adversarial Imitation Learning", ARXIV.ORG, CORNELL UNIVERSITY LIBRARY, 201 OLIN LIBRARY CORNELL UNIVERSITY ITHACA, NY 14853, 10 June 2020 (2020-06-10), XP081695086, * abstract; figure 1 * <br> * page 3, paragraph 1 * <br> * page 11, paragraph 2 * <br> * page 14, paragraph 1-2 * <br> * page 18, paragraph 3 * <br> * the whole document * | 2-4,8 | **TECHNICAL FIELDS SEARCHED (IPC)** |

The present search report has been drawn up for all claims

| Place of search | Date of completion of the search | Examiner |
|---|---|---|
| Munich | 12 May 2023 | Dapp, Wolfgang |

## ANNEX TO THE EUROPEAN SEARCH REPORT
## ON EUROPEAN PATENT APPLICATION NO.

EP 22 21 4488

This annex lists the patent family members relating to the patent documents cited in the above-mentioned European search report.
The members are as contained in the European Patent Office EDP file on
The European Patent Office is in no way liable for these particulars which are merely given for the purpose of information.

12-05-2023

| Patent document cited in search report | | Publication date | Patent family member(s) | | Publication date |
|---|---|---|---|---|---|
| US 2020074266 | A1 | 05-03-2020 | US | 2020074230 A1 | 05-03-2020 |
| | | | US | 2020074233 A1 | 05-03-2020 |
| | | | US | 2020074266 A1 | 05-03-2020 |